# EUROPEAN PATENT SPECIFICATION

(11) **EP 3 432 458 B1**
(45) Date of publication and mention of the grant of the patent: **28.07.2021**
(21) Application number: 17785726.5
(22) Date of filing: 23.03.2017
(51) Int. Cl.: H02M 3/155, H05K 5/06, H05K 7/02, H05K 7/14

(54) **POWER SUPPLY MODULE AND POWER SUPPLY DEVICE**
STROMVERSORGUNGSMODUL UND STROMVERSORGUNGSVORRICHTUNG
MODULE ET DISPOSITIF D'ALIMENTATION ÉLECTRIQUE

(30) Priority: 21.04.2016 JP 2016084990
(43) Date of publication of application: 23.01.2019
(73) Proprietor: Murata Manufacturing Co., Ltd., Nagaokakyo-shi, Kyoto 617-8555 (JP)
(72) Inventor: TANGE Takayuki, Nagaokakyo-shi Kyoto 617-8555 (JP); HIGASHIDE Yasuhiro, Nagaokakyo-shi Kyoto 617-8555 (JP); WAKE Takeshi, Nagaokakyo-shi Kyoto 617-8555 (JP); MIYASHITA Munetake, Nagaokakyo-shi Kyoto 617-8555 (JP)
(74) Representative: Herrmann, Uwe
(86) International application number: PCT/JP2017/011582
(87) International publication number: WO 2017/183384

(56) References cited:
- CN-A- 105 099 193
- JP-A- 2004 221 225
- JP-A- 2004 289 912
- JP-A- 2004 289 912
- JP-A- 2013 046 509
- JP-U- H0 666 291
- US-A1- 2011 182 039
- US-A1- 2012 063 038
- US-A1- 2015 303 814

## Description

### Technical Field

The present invention relates to a power supply module, and more particularly to a power supply module that includes a substrate and a plurality of electronic components mounted on the substrate. The present invention also relates to a power supply device that includes the power supply module and a mounting substrate.

### Background Art

In the related art, a DC-DC converter module is known that has a structure in which an electronic component, such as an IC chip, is directly mounted on the top surface of a chip inductor (JP 2010-287684 A).

In the above-mentioned DC-DC converter module, a plurality of electronic components are mounted onto the top surface of a chip inductor, and thus, reduction in the size of the DC-DC converter module is achieved.

An embodiment of a power-supply module according to US 2012/063 038 A1 includes a package having sides, a first power-supply component disposed in the package, and an electromagnetic-interference (EMI) shield disposed adjacent to two sides of the package. For example, such a module may include component-mounting platforms (e.g., a lead frame or printed circuit board) on the top and bottom sides of the module, and these platforms may provide a level of EMI shielding specified for a particular application. Consequently, such a module may provide better EMI shielding than modules with shielding along only one side (e.g., the bottom) of the module. Moreover, if the module components are mounted to, or otherwise thermally coupled to, the shielding platforms, then the module may provide multi-side cooling of the components.

A composite module is obtained in US 2011/182039 A1 which enables high-density mounting of components without increasing its size. A composite module includes a main substrate which is a multilayer circuit board, a sub-substrate mounted on a lower surface of the main substrate, a sealing layer arranged on the lower surface of the main substrate to cover the sub-substrate, the sealing layer defining a mount surface arranged to be mounted on a mount board, and terminal electrodes disposed on the mount surface. The terminal electrodes include at least one first terminal electrode drawn directly from the main substrate and at least one second terminal electrode drawn directly from the sub-substrate.

JP 2004 289912 A provides a slim power supply unit and its manufacturing method capable of achieving further miniaturization and slimming than a conventional one. In this DC power supply unit disposed with parts necessary for power conversion such as semiconductors for power supply, inductors and capacitors, respective constituent elements are constructed into a layered structure and are connected in combination with wiring patterns and flip-chip wiring on a mouting substrate.

CN 105 099 193 A provides a DC/DC power supply device, which comprises a plurality of power boards, a control board and a main board, and is characterized in that the plurality of power board are mutually connected in parallel, and each power board comprises a bearing circuit board and a power device placed on the bearing circuit board; the control board comprises a feedback control circuit and a pulse width modulation generating circuit, the feedback control circuit is used for receiving one or more feedback signals from the power boards, and the pulse width modulation generating circuit outputs pulse width modulation control signals to the power boards according to the feedback signals; and the main board is electrically connected with the power boards and the control board.

JP 2004 221225 A provides a thin DC power supply unit capable of improving heat radiation characteristics and reducing the size and thickness, and a method for manufacturing the thin DC power supply unit. The thin DC power supply unit is equipped with components including semiconductors for power supplies, inductors, capacitors, and the like required for converting power. In the thin DC power supply unit, the input terminal wiring pattern, the output terminal wiring pattern, and the ground terminal wiring pattern are formed on an IC bare chip for power supply control for composing the semiconductor for power supplies; and the components, such as the inductors and the capacitors, required for converting power are provided on the input, output, and ground terminal wiring patterns. Arrangement is made on a silicon substrate having high thermal conductivity, thus obtaining the thin DC power supply unit in which the heat radiation characteristics are improved and the size and thickness are reduced.

### Summary of Invention

### Technical Problem

However, with the recent reduction in the sizes of electronic devices, there has been a demand for high densification and high integration of discrete components, package modules, and the like that are mounted onto mounting substrates, and the module having the structure described in Patent Document 1 has a problem in that the footprint is large.

It is an object of the present invention to provide a power supply module capable of further reducing a footprint by employing a simple configuration and a power supply device that includes the power supply module and a mounting substrate.

### Solution to Problem

(1) A power supply module according to the present invention has a first outer surface and a second outer surface that is adjacent to the first outer surface and perpendicular to the first outer surface and includes a substrate that has a first surface and a side surface, a plurality of electronic components that are mounted at least on the first surface, a first resin member that is formed on the first surface and that seals the electronic components mounted on the first surface, and a terminal electrode that is exposed at least at the first outer surface. In the substrate, the first surface is perpendicular to the first outer surface. The first outer surface is formed so as to extend at least across the side surface of the substrate and the first resin member. An area of the first outer surface is smaller than an area of the second outer surface, and the first outer surface is configured as a mounting surface.
   With this configuration, a power supply module having a smaller footprint than that in the case where the second outer surface serves as a mounting surface (i.e., the case of a structure in which the first surface of the substrate is parallel to the mounting surface) can be realized.
   In addition, in this configuration, the plurality of electronic components mounted on the first surface of the substrate 1 are sealed by the first resin member. In other words, the thickness of the first resin member is equal to or greater than a thickness required for sealing the plurality of electronic components mounted on the first surface. That is to say, the area of the first outer surface required for stable mounting is ensured. Therefore, with this configuration, a power supply module that can be stably mounted while having a small footprint can be realized.
(2) In the above (1), according to the invention, the substrate further has a second surface that is opposite to the first surface and perpendicular to the first outer surface and that some of the plurality of electronic components are mounted on the second surface. In addition, the power supply module further includes a second resin member that is formed on the second surface and that seals the electronic components mounted on the second surface, and the first outer surface is formed so as to further include the second resin member. With this configuration, a power supply module that is smaller in size than that in the case where the plurality of electronic components are mounted on one of the first surface and the second surface of the substrate can be realized.
(3) In the above (2), it is preferable that the power supply module further include an inductor that is mounted on the first surface or the second surface and sealed by the first resin member or the second resin member and that some of the plurality of electronic components be disposed at positions at which the some of the plurality of electronic components overlap the inductor when the first surface or the second surface is viewed in plan view. In the power supply module, the inductor is a component having a relatively large size. Therefore, with this configuration, the power supply module can be easily reduced in size.
(4) In the above (3), the plurality of electronic components may include an input capacitor that is connected to an input portion, an output capacitor that is connected to an output portion, and a switching element that is connected between the inductor and the input capacitor or between the inductor and the output capacitor and that switches on and off a current that flows through the inductor, and the input capacitor and the output capacitor may be mounted on one of the first surface and the second surface. In addition, the switching element may be mounted on one of the first surface and the second surface, the one surface being different from the other surface on which the input capacitor and the output capacitor are mounted.
(5) In the above (3), the plurality of electronic components may include an input capacitor that is connected to an input portion, an output capacitor that is connected to an output portion, and at least one switching element that is connected between the inductor and the input capacitor and between the inductor and the output capacitor and that switches on and off a current that flows through the inductor, and the input capacitor and the output capacitor may be mounted on one of the first surface and the second surface. In addition, the switching element may be mounted on one of the first surface and the second surface, the one surface being different from the other surface on which the input capacitor and the output capacitor are mounted.
(6) In the above (4) or (5), it is preferable that the switching element be disposed at a position where at least a portion of the switching element overlaps at least one of the input capacitor and the output capacitor when the first surface or the second surface is viewed in plan view. With this configuration, the distance between the switching element and the input capacitor or the output capacitor on a plane is shorter than that in the case where the switching element and the capacitor are arranged on the same surface of the substrate, and thus, the length of a wiring line between the switching element and the input capacitor or the output capacitor is short. Thus, the inductance and the conductor resistance of a loop of the power supply module are reduced, and an effect of suppressing switching noise, the effect being obtained by the input capacitor and the output capacitor is improved. Therefore, conducted noise from the power supply module to, for example, a conductor pattern formed in or on the substrate is reduced. In addition, radiation noise from the power supply module to the outside is reduced. Furthermore, with this configuration, the power conversion efficiency of the power supply module is improved.
(7) In one of the above (4) to (6), it is preferable that the power supply module further include a conductor that is formed in or on the substrate and that the switching element be disposed at a position where at least a portion of the switching element overlaps the conductor when the first surface or the second surface is viewed in plan view. In this configuration, the conductor formed in or on the substrate functions as a shield that blocks noise emitted from the switching element, and thus, noise that is emitted from the power supply module can be suppressed.
(8) In one of the above (1) to (7), it is preferable that the terminal electrode be formed so as to extend from a portion of the first outer surface to a portion of the second outer surface. In this configuration, not only the first outer surface but also the second outer surface can be used as the mounting surfaces, and thus, a power supply module having mounting surfaces that are selectable in accordance with the space of a target on which the power supply module is to be mounted can be realized.
(9) In one of the above (1) to (8), a plurality of the terminal electrodes may be provided, and the plurality of terminal electrodes may be arranged in a first direction along a ridge of the first outer surface and the second outer surface.
(10) A power supply device according to the present invention includes a mounting substrate and a plurality of power supply modules each of which has a first outer surface and a second outer surface that is adjacent to the first outer surface and perpendicular to the first outer surface. Each of the plurality of power supply modules includes a substrate that has a first surface and a second surface, a plurality of electronic components that are mounted at least on the first surface, a first resin member that is formed on the first surface and that seals the electronic components mounted on the first surface, and a terminal electrode that is exposed at least at the first outer surface. In the substrate, the first surface is perpendicular to the first outer surface. The first outer surface is formed so as to extend at least across the side surface of the substrate and the first resin member. An area of the first outer surface is smaller than an area of the second outer surface. The plurality of power supply modules are arranged in a second direction that is perpendicular to a first direction along a ridge of the first outer surface and the second outer surface and are electrically connected in parallel to each other.
   With this configuration, the length of a wiring line (a conductor pattern having high conductor resistance) for connecting a plurality of power supply modules to each other can be shorter than that in the case where a power supply module having a structure in which a substrate thereof has a first surface and a second surface that are parallel to a mounting surface is mounted onto the mounting substrate, and thus, a low-loss power supply device can be realized. In addition, with this configuration, a plurality of power supply modules can be connected in parallel to each other by simple wiring. Therefore, it is not necessary to route a complex wiring line for connecting a plurality of power supply modules in parallel to each other, and the plurality of power supply modules may easily be connected to each other.
   With this configuration, a plurality of power supply modules can be connected in parallel to each other at the shortest distance, and thus, unstable operation of the power supply device due to exogenous noise is suppressed. In addition, by connecting the plurality of power supply modules in parallel to each other at the shortest distance, variations in load current between the power supply modules 101 due to a difference in the wiring length can be reduced, and the operational stability of the power supply device is improved.
(11) In the above (10), the plurality of power supply modules may be mounted on the mounting substrate by using solder.

### Advantageous Effects of Invention

According to the present invention, a power supply module capable of further reducing a footprint by employing a simple configuration and a power supply device that includes the power supply module and a mounting substrate can be realized.

### Brief Description of Drawings

[Fig. 1] Fig. 1(A) is a perspective view of a power supply module 101 according to a first embodiment, and Fig. 1(B) is a perspective view of the power supply module 101 when viewed from a direction different from that of Fig. 1(A).
[Fig. 2] Fig. 2(A) is a perspective view illustrating an internal structure of the power supply module 101, and Fig. 2(B) is a front view of the power supply module 101.
[Fig. 3] Fig. 3(A) is a left-hand side view of the power supply module 101, and Fig. 3(B) is a right-hand side view of the power supply module 101.
[Fig. 4] Fig. 4 is a circuit diagram of the power supply module 101.
[Fig. 5] Fig. 5 is a front view of a power supply module 102 according to a second embodiment.
[Fig. 6] Fig. 6(A) is a left-hand side view of the power supply module 102, and Fig. 6(B) is a right-hand side view of the power supply module 102.
[Fig. 7] Fig. 7 is a circuit diagram of the power supply module 102.
[Fig. 8] Fig. 8(A) is a front view of a power supply module 103 according to a third embodiment, and Fig. 8(B) is a left-hand side view of the power supply module 103.
[Fig. 9] Fig. 9(A) is a circuit diagram of a power supply module 104A according to a fourth embodiment, and Fig. 9(B) is a circuit diagram of another power supply module 104B according to the fourth embodiment.
[Fig. 10] Fig. 10 is a plan view illustrating a principal portion of a power supply device 201 according to a fifth embodiment that includes power supply modules according to the present invention.
[Fig. 11] Fig. 11 is a plan view illustrating a principal portion of a power supply device 200 of a comparative example that includes power supply modules 100. Description of Embodiments

A plurality of embodiments of the present invention will be described below using some specific examples with reference to the drawings. The same members illustrated in the drawings are denoted by the same reference signs. Although the embodiments will be separately described for ease of explaining and understanding the gist of the present invention, the configurations described in the different embodiments may be partially replaced with one another or may be combined with one another. In a second embodiment and the subsequent embodiments, descriptions of matters that are common to a first embodiment will be omitted, and only differences will be described. In particular, similar advantageous effects obtained with similar configurations will not be described in every embodiment.

### «First Embodiment»

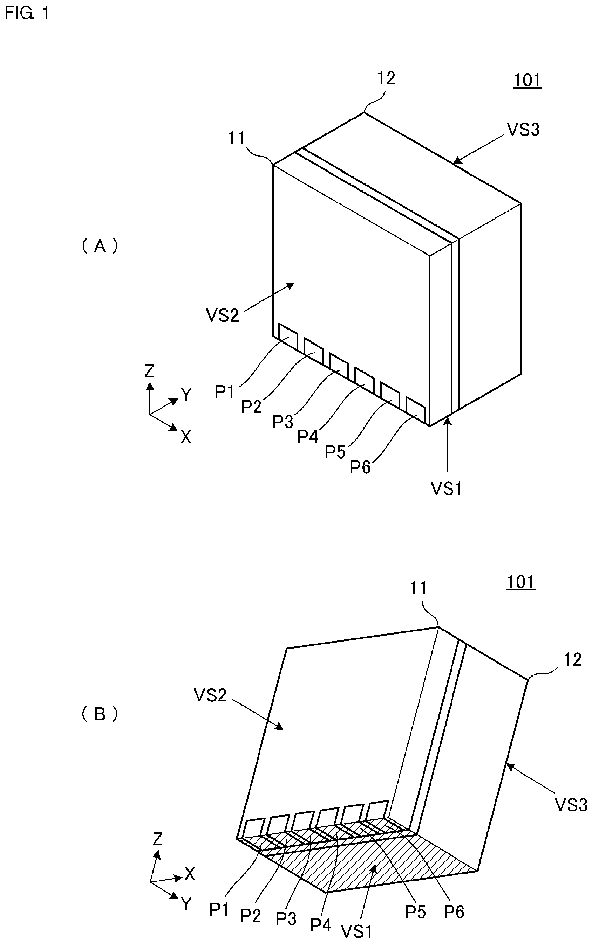

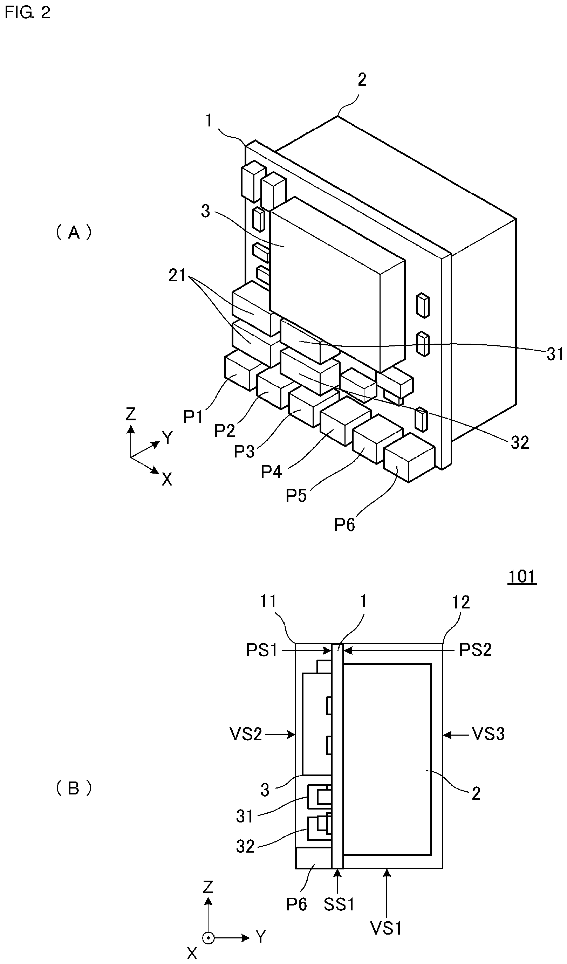

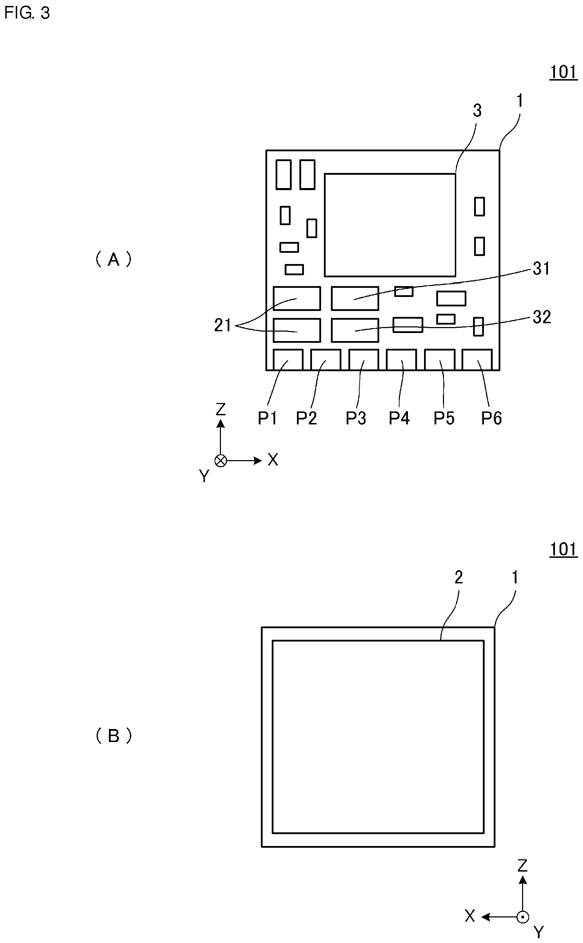

Fig. 1(A) is a perspective view of a power supply module 101 according to the first embodiment, and Fig. 1(B) is a perspective view of the power supply module 101 when viewed from a direction different from that of Fig. 1(A). Fig. 2(A) is a perspective view illustrating an internal structure of the power supply module 101, and Fig. 2(B) is a front view of the power supply module 101. Fig. 3(A) is a left-hand side view of the power supply module 101, and Fig. 3(B) is a right-hand side view of the power supply module 101.

In Fig. 1(B), for ease of understanding of the structure, a first outer surface VS1 is illustrated by hatching. In Fig. 2(A), for ease of understanding of the structure, a first resin member 11 and a second resin member 12 are not illustrated. In addition, in Fig. 2(B), Fig. 3(A), and Fig. 3(B), for ease of understanding of the structure, the first resin member 11 and the second resin member 12 are illustrated as being transparent.

In the present embodiment, a case where the power supply module 101 is a step-down DC-DC converter module will be described. The power supply module 101 is a module that has a rectangular parallelepiped shape and that has the first outer surface VS1 that is parallel to an X-axis direction and a Y-axis direction, a second outer surface VS2, and a third outer surface VS3. In the present embodiment, the first outer surface VS1 is a mounting surface of the power supply module 101. The second outer surface VS2 and the third outer surface VS3 are adjacent to the first outer surface VS1 and are perpendicular to the first outer surface VS1.

Note that, in the present specification, the wording "a surface A and a surface B are perpendicular to each other" is not limited to the case where the surface A and the surface B intersect each other exactly at 90 degrees and includes the case where the surface A and the surface B are substantially perpendicular to each other in consideration of design and manufacturing tolerances and the like. This is common to the subsequent embodiments.

The power supply module 101 includes a substrate 1, an inductor 2, a control IC 3, two capacitors 21, switching elements 31 and 32, the first resin member 11, the second resin member 12, and six terminal electrodes P1, P2, P3, P4, P5, and P6.

The substrate 1 is a flat plate having a rectangular shape in plan view and has a first surface PS1, a second surface PS2 facing the first surface PS1, and a side surface SS1. The first surface PS1 and the second surface PS2 of the substrate 1 are surfaces that are parallel to in the X-axis direction and the Z-axis direction. The side surface SS1 is adjacent to the first surface PS1 and the second surface PS2 and is perpendicular to the first surface PS1 and the second surface PS2. As illustrated in Fig. 2(B), the first surface PS1 and the second surface PS2 of the substrate 1 are perpendicular to the first outer surface VS1 and parallel to the second outer surface VS2 and the third outer surface VS3. The substrate 1 is a printed wiring board containing, for example, a thermosetting resin such as an epoxy resin.

The control IC 3, the two capacitors 21, and the switching elements 31 and 32 are installed (mounted) on the first surface PS1 of the substrate 1, and the inductor 2 is installed (mounted) on the second surface PS2 of the substrate 1. The control IC 3 is, for example, a microprocessor chip or an IC chip. The two capacitors 21 are an input capacitor and an output capacitor and are, for example, ceramic chip capacitors. The switching elements 31 and 32 are, for example, FETs. The inductor 2 is, for example, a chip inductor. The control IC 3, the two capacitors 21, and the switching elements 31 and 32 are mounted on the first surface PS1 of the substrate 1 by using, for example, an electrically conductive bonding material such as solder.

In the present embodiment, the control IC 3, the two capacitors 21, the switching elements 31 and 32, and the like correspond to "a plurality of electronic components that are mounted on the first surface" according to the present invention.

As illustrated in Fig. 3(B), the inductor 2 is mounted over substantially the entire second surface PS2 of the substrate 1. Thus, each of the plurality of electronic components (the control IC 3, the capacitors 21, the switching elements 31 and 32, and the like) is disposed at a position where the electronic component overlaps the inductor 2 when the first surface PS1 or the second surface PS2 is viewed in plan view (viewed in the Y-axis direction). The inductor 2 is mounted on the second surface PS2 of the substrate 1 by using, for example, an electrically conductive bonding material such as solder.

The first resin member 11 is formed on the first surface PS1 of the substrate 1 and is a resin block that has a rectangular parallelepiped shape and that seals the control IC 3, the two capacitors 21 (corresponding to "an input capacitor" and "an output capacitor" according to the present invention), and the switching elements 31 and 32, which are mounted on the first surface PS1. In other words, the control IC 3, the two capacitors 21, and the switching elements 31 and 32 are buried in the first resin member 11 formed on the first surface PS1 of the substrate 1. The first resin member 11 is made of, for example, a thermosetting resin such as an epoxy resin.

The second resin member 12 is formed on the second surface PS2 of the substrate 1 and is a resin block that has a rectangular parallelepiped shape and that seals the inductor 2, which is mounted on the second surface PS2. In other words, the inductor 2 is buried in the second resin member 12 formed on the second surface PS2 of the substrate 1. The second resin member 12 is made of, for example, a thermosetting resin such as an epoxy resin.

As illustrated in Fig. 1(B) and Fig. 2(B), the first outer surface VS1 of the power supply module 101 is formed so as to extend across the side surface SS1 of the substrate 1, the first resin member 11, and the second resin member 12. The second outer surface VS2 of the power supply module 101 is formed at the first resin member 11. As illustrated in Fig. 1(B) and the like, the area of the first outer surface VS1 is smaller than the area of the second outer surface VS2.

The power supply module 101 according to the present embodiment has a structure in which the plurality of electronic components, which are mounted on the first surface PS1 of the substrate 1, are sealed by the first resin member 11. In other words, the thickness of the first resin member 11 (the thickness of the first resin member 11 in a direction (the Y-axis direction) perpendicular to the first surface PS1 of the substrate 1) is equal to or greater than a thickness required for sealing the plurality of electronic components mounted on the first surface PS1. In addition, the power supply module 101 has a structure in which the inductor 2, which is mounted on the second surface PS2 of the substrate 1, is sealed by the second resin member 12. In other words, the thickness of the second resin member 12 (the thickness of the second resin member 12 in the Y-axis direction) is equal to or greater than a thickness required for sealing the inductor 2 mounted on the second surface PS2.

Thus; the width of the power supply module (the dimension of the power supply module in the Y-axis direction) is equal to or greater than a width required for the above-described structures. That is to say, the area of the first outer surface VS1 required for stable mounting of the power supply module is ensured.

The terminal electrodes P1, P2, P3, P4, P5, and P6 are columnar electrodes for connecting to outer electrodes and are each buried in the first resin member 11 such that at least a portion thereof is exposed at the first outer surface VS1. Each of the terminal electrodes P1, P2, P3, P4, P5, and P6 is mounted on the first surface PS1 of the substrate 1 and is connected to a conductor pattern or the like formed in or on the substrate 1. In the present embodiment, the terminal electrodes P1, P2, P3, P4, P5, and P6 are located on a first side of the substrate 1 (a lower side of the substrate 1 in Fig. 3(A)) and are exposed at the first outer surface VS1 and the second outer surface VS2. As illustrated in Fig. 1(B), the terminal electrodes P1, P2, P3, P4, P5, and P6 are formed so as to extend from a portion of the first outer surface VS1 to a portion of the second outer surface VS2 and are arranged in a first direction (the X-axis direction) along the ridge of the first outer surface VS1 and the second outer surface VS2. Each of the terminal electrodes P1, P2, P3, P4, P5, and P6 is, for example, a block that is made of copper and that has a rectangular parallelepiped shape.

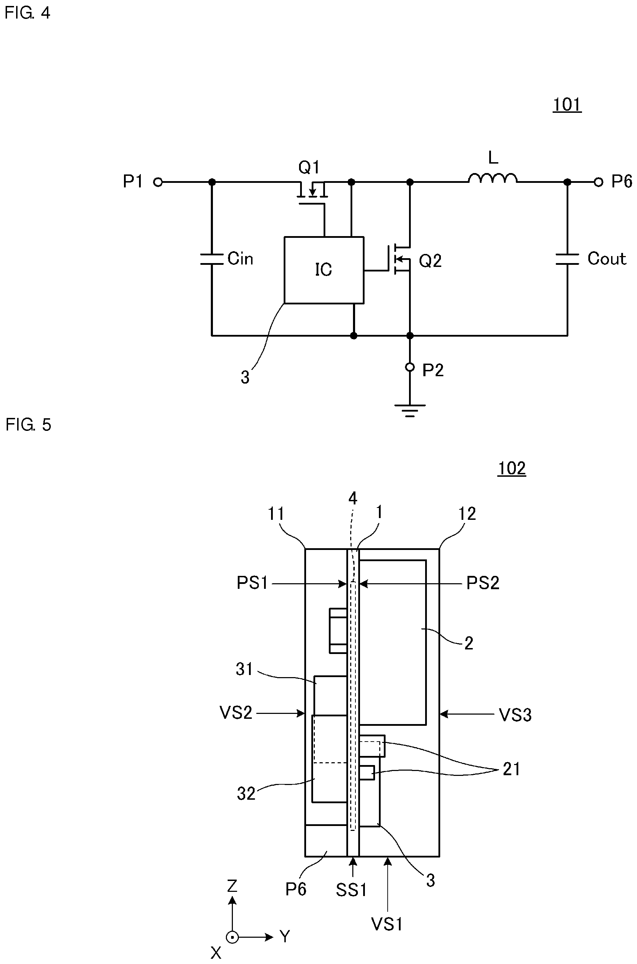

Fig. 4 is a circuit diagram of the power supply module 101. In Fig. 4, the inductor 2, the two capacitors 21, and the switching elements 31 and 32, which are illustrated in Fig. 3(A), Fig. 3(B), and the like, are respectively represented by an inductor L, an input capacitor Cin, an output capacitor Cout, and switching elements Q1 and Q2. In Fig. 4, the terminal electrode P1 is a voltage-input portion that receives a DC voltage, and the terminal electrode P2 is a ground. The terminal electrode P6 is a voltage-output portion.

The inductor L and the switching element Q1 are connected between the terminal electrode P1 and the terminal electrode P6. The switching elements Q1 and Q2 are elements that switch on and off a current that flows through the inductor L. The switching element Q1 is connected between the terminal electrode P1 and the inductor L, and the switching element Q2 is connected between the terminal electrode P2 (the ground) and the inductor L. The input capacitor Cin is connected between the terminal electrode P1 and the terminal electrode P2 (the ground), and the output capacitor Cout is connected between the terminal electrode P6 and the ground. The control IC 3 is connected between the switching elements Q1 and Q2.

More specifically, a drain of the switching element Q1 is connected to the terminal electrode P1, and a source of the switching element Q1 is connected to a first end of the inductor L. A second end of the inductor L is connected to the terminal electrode P6. A drain of the switching element Q2 is connected to the first end of the inductor L, and a source of the switching element Q2 is connected to the terminal electrode P2 (the ground). A first end of the input capacitor Cin is connected to the terminal electrode P1, and a second end of the input capacitor Cin is connected to the terminal electrode P2 (the ground). A first end of the output capacitor Cout is connected to the terminal electrode P6, and a second end of the output capacitor Cout is connected to the terminal electrode P2 (the ground). The control IC 3 is connected to the gate and the source of each of the switching elements Q1 and Q2.

As described above, the power supply module 101 forms a step-down DC-DC converter module.

The power supply module 101 according to the present embodiment exhibits the following advantageous effects.
(a) The power supply module 101 has a structure in which the plurality of electronic components and the inductor 2 are mounted on the first surface PS1 and the second surface PS2 of the substrate 1 and in which the first surface PS1 and the second surface PS2 are perpendicular to the first outer surface VS1, which is the mounting surface. In addition, in the power supply module 101, the area of the first outer surface VS1 is smaller than the area of the second outer surface VS2. With this configuration, a power supply module having a smaller footprint than that in the case where the second outer surface VS2 serves as the mounting surface (i.e., the case of a structure in which the first surface PS1 and the second surface PS2 of the substrate 1 are parallel to the mounting surface) can be realized.
(b) The power supply module 101 has the structure in which the plurality of electronic components mounted on the first surface PS1 of the substrate 1 are sealed by the first resin member 11 and in which the inductor 2 mounted on the second surface PS2 is sealed by the second resin member 12. In other words, the thickness of the first resin member 11 in the Y-axis direction is equal to or greater than the thickness required for sealing the plurality of electronic components mounted on the first surface PS1, and the thickness of the second resin member 12 in the Y-axis direction is equal to or greater than the thickness required for sealing the inductor 2 mounted on the second surface PS2. That is to say, with this configuration, the area of the first outer surface VS1 required for stable mounting is ensured. Therefore, a power supply module that can be stably mounted while having a small footprint (even with the structure in which the first outer surface VS1 is perpendicular to the first surface PS1 and the second surface PS2 of the substrate 1) can be realized.
(c) In the structure according to the present embodiment, the inductor is mounted on the second surface PS2 of the substrate 1, and the plurality of electronic components are mounted on the first surface PS1 of the substrate 1. Therefore, a power supply module that is smaller in size (particularly having smaller dimensions in the X-axis direction and the Z-axis direction) than that in the case where the inductor and the plurality of electronic components are mounted on one of the first surface PS1 and the second surface PS2 of the substrate 1 can be realized.
(d) In the present embodiment, the terminal electrodes P1, P2, P3, P4, P5, and P6 are formed so as to extend from a portion of the first outer surface VS1 to a portion of the second outer surface VS2 and are exposed at the first outer surface VS1 and the second outer surface VS2. In this configuration, not only the first outer surface VS1 but also the second outer surface VS2 can be used as the mounting surface, and thus, a power supply module having mounting surfaces that are selectable in accordance with the space of a target on which the power supply module is to be mounted can be realized.
(e) In the present embodiment, each of the plurality of electronic components (the control IC 3, the capacitors 21, the switching elements 31 and 32, and the like) is disposed at the position where the electronic component overlaps the inductor 2 when viewed in the Y-axis direction. In the power supply module, the inductor 2 is a component having a relatively large size. Thus, with this configuration, the power supply module can be easily reduced in size. Note that it is not necessary for all the plurality of electronic components to overlap the inductor 2 when viewed in the Y-axis direction. As will be described later (see the second embodiment), advantageous effects such as those described above may be obtained as long as some of the plurality of electronic components overlap the inductor 2 when viewed in the Y-axis direction.
(f) In the present embodiment, the electronic components (the control IC 3, the capacitors 21, and the switching elements 31 and 32) mounted on the first surface PS1 are sealed by the first resin member 11, and the inductor 2 mounted on the second surface is sealed by the second resin member 12. In this configuration, since the electronic components and the inductor 2 are protected with the resin members, the entire power supply module is sturdy, and the mechanical strength of the power supply module and the durability of the power supply module with respect to an external force and the like are improved. In addition, with this configuration, the mounting strength of each of the electronic components with respect to the substrate 1 can be further improved compared with the case where the electronic components are mounted on the substrate 1 only by soldering, and the electrical connection reliability between the electronic components and the like and the substrate is improved.
   Furthermore, in this configuration, since the electronic components mounted on the substrate 1 are sealed by the resin material, an electronic component, a semiconductor bare chip component (IC), and the like each having low component strength can also be directly mounted on the substrate 1 by face-down mounting. Consequently, a lead frame and wire bonding are not necessary, and the size in the module is small. Therefore, by using such a bare chip component, reduction in the size of the power supply module can be facilitated.
(g) In the present embodiment, the electronic components such as the switching elements 31 and 32, the control IC 3, and the like that generate heat during operation (hereinafter referred to as heat generating components) are sealed by the resin material that has a thermal conductivity higher than that of air. Accordingly, the heat generated by each of the heat generating components is dispersed through the resin member, and thus, heat-dissipation performance is improved.
(h) In the present embodiment, the heat generating components (the switching elements 31 and 32 and the like) are mounted on the first surface PS1 and sealed by the first resin member 11 at which the mounting surface (the first outer surface VS1) of the power supply module is formed. When the power supply module having this configuration is mounted on a mounting substrate, gaps between the heat generating components and the mounting substrate are filled with the resin member such that the heat generating components are in contact with the mounting substrate via the resin member. Therefore, with this configuration, the heat generated by each of the heat generating components is more easily dispersed to the mounting substrate compared with the case where a power supply module having a structure in which heat generating components are not sealed by a resin member is mounted on a mounting substrate, and the heat-dissipation performance is further improved.
(i) In the case where the power supply module has a structure in which the first surface PS1 and the second surface PS2 of the substrate 1 are not sealed by a resin member, it is necessary to ensure the strength of the substrate 1 in order to mount the electronic components, and thus, it is difficult to form the substrate 1 to be thin. In contrast, in the present embodiment, since the first surface PS1 and the second surface PS2 of the substrate 1 are sealed by the resin members, even if the substrate 1 is formed thin, the strength of the substrate 1 for mounting the electronic components is ensured, and the probability of warpage and the like occurring in the substrate 1 is reduced. Therefore, with this embodiment, the substrate 1, which is formed thin, can be easily used, so that a power supply module that is small in size (particularly having a small thickness in the Y-axis direction) can be realized.

Note that, by forming the substrate 1 to be thin, the wiring length of an interlayer connection conductor or the like that connect the first surface PS1 and the second surface PS2 of the substrate 1 to each other can be shortened, so that the conductor resistance of the entire power supply module can be reduced. Therefore, a low-loss power supply module can be realized.

### <<Second Embodiment>>

In the second embodiment, a case of the power supply module in which electronic components, in addition to the inductor, are mounted on the second surface PS2 of the substrate 1 will be described.

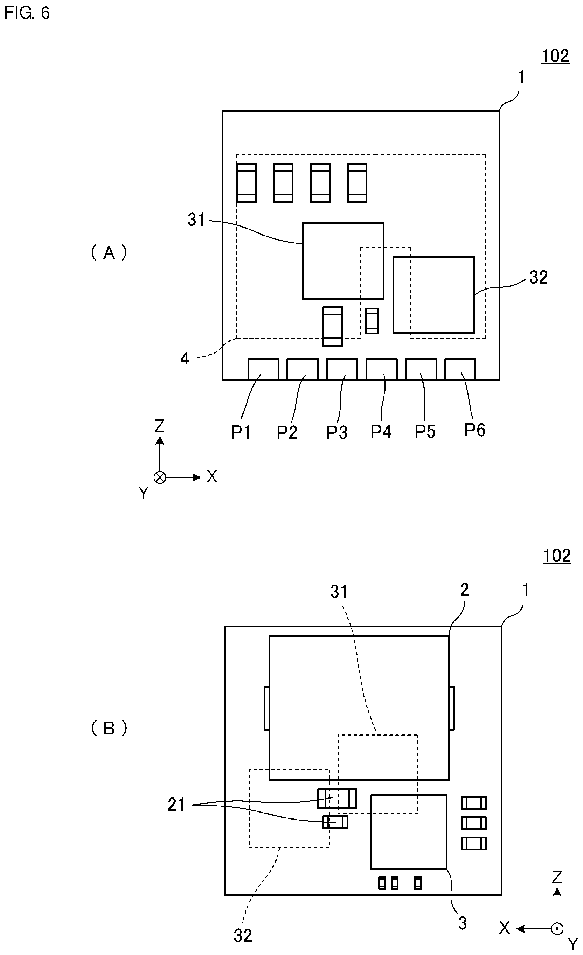

Fig. 5 is a front view of a power supply module 102 according to the second embodiment. Fig. 6(A) is a left-hand side view of the power supply module 102, and Fig. 6(B) is a right-hand side view of the power supply module 102. In Fig. 5, Fig. 6(A), and Fig. 6(B), for ease of understanding of the structure of the power supply module 102, the first resin member 11 and the second resin member 12 are illustrated as being transparent. In addition, in Fig. 6(B), the positions of the switching elements 31 and 32 are indicated by dashed lines for ease of understanding of the structure, and in Fig. 6(A), the position of a conductor 4 is indicated by a dashed line for ease of understanding of the structure.

A difference between the power supply module 102 according to the present embodiment and the power supply module 101 according to the first embodiment is that some of the plurality of electronic components (the control IC 3 and the two capacitors 21) are mounted on the second surface PS2 of the substrate 1. Another difference between the power supply module 102 and the power supply module 102 is that the power supply module 102 includes the conductor 4 formed in the substrate 1. The rest of the configuration of the power supply module 102 is substantially the same as that of the power supply module 101.

The conductor 4 is a conductor pattern that is formed in the substrate 1 and that has a U-shape (a C-shape) in plan view. The conductor 4 is, for example, a ground conductor that is formed in the substrate 1.

The control IC and the two capacitors 21 (the input capacitor and the output capacitor) are mounted on the second surface PS2 of the substrate 1 and are sealed by the second resin member 12 that is formed on the second surface PS2 of the substrate 1. In the present embodiment, the switching elements 31 and 32 are mounted on one of the first surface PS1 and the second surface PS2, the one surface (the first surface PS1) being different from the other surface (the second surface PS2) on which the capacitors 21 (the input capacitor and the output capacitor) are mounted.

In the present embodiment, the switching elements 31 and 32 and the like correspond to "a plurality of electronic components that are mounted on the first surface" according to the present invention. In addition, in the present embodiment, the control IC 3 and the capacitors 21 (the input capacitor and the output capacitor) correspond to "a plurality of electronic components that are mounted on the second surface" according to the present invention.

As illustrated in Fig. 6(B), the switching elements 31 and 32 according to the present embodiment are disposed at positions where at least a portion of each of the switching elements 31 and 32 overlaps the capacitors 21 (at least one of the input capacitor and the output capacitor) when viewed in the Y-axis direction. In addition, as illustrated in Fig. 6(A), the switching elements 31 and 32 are disposed at positions where a portion of each of the switching elements 31 and 32 overlaps the conductor 4 when viewed in the Y-axis direction.

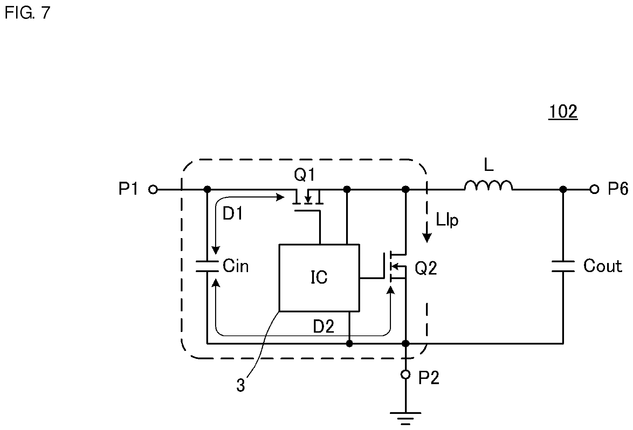

Fig. 7 is a circuit diagram of the power supply module 102. As illustrated in Fig. 7, in the power supply module 102, the input capacitor Cin and the switching elements Q1 and Q2 form a loop LIp.

The power supply module 102 according to the present embodiment exhibits the following advantageous effects in addition to the advantageous effects described in the first embodiment.
(j) In the present embodiment, the switching elements 31 and 32 are disposed at the positions where at least a portion of each of the switching elements 31 and 32 overlaps the capacitors 21 (at least one of the input capacitor and the output capacitor) when viewed in the Y-axis direction. With this configuration, the distance between each of the switching elements 31 and 32 and the input capacitor (or the output capacitor) on a plane (an XZ plane) is shorter than that in the case where the switching elements 31 and 32 and the capacitors 21 are arranged on the same surface of the substrate 1, and thus, the length of a wiring line between each of the switching elements 31 and 32 and the input capacitor (or the output capacitor) is short (specifically, the sections D1 and D2 in Fig. 7 are short). Thus, the inductance and the conductor resistance of the loop LIp of the power supply module 102 are reduced, and an effect of suppressing switching noise, the effect being obtained by the input capacitor (or the output capacitor) is improved. Therefore, conducted noise from the power supply module to, for example, a conductor pattern formed in or on the substrate 1 is reduced. In addition, radiation noise from the power supply module to the outside is reduced. Furthermore, with this configuration, the power conversion efficiency of the power supply module is improved. Note that, regarding the improvement in the power conversion efficiency of the power supply module, which has been mentioned above, the effect increases particularly in an operation at high frequency.
   In addition, by forming the substrate 1 to be thin as mentioned above, the wiring length of the interlayer connection conductor or the like that connect the first surface PS1 and the second surface PS2 of the substrate 1 to each other can be shortened, so that the conductor resistance can be further reduced, and the power conversion efficiency of the power supply module can be further improved.
(k) In the present embodiment, the switching elements 31 and 32 are disposed at the positions where at least a portion of each of the switching elements 31 and 32 overlaps the conductor 4 when viewed in the Y-axis direction. In this configuration, the conductor 4, which is formed in the substrate 1, functions as a shield that blocks noise emitted from the switching elements 31 and 32, and thus, noise that is emitted from the power supply module can be suppressed. In the present embodiment, particularly, noise that is emitted toward the third outer surface VS3 of the power supply module, which is opposite to the first surface PS1 of the substrate 1 on which the switching elements 31 and 32 are mounted, can be suppressed.

Note that, in the present embodiment, although the case has been described in which the conductor 4 is formed in the substrate 1 and is a conductor pattern having a U-shape (a C-shape) in plan view, the present invention is not limited to this configuration. The conductor 4 may be formed on the first surface PS1 of the substrate 1 or may be formed on the second surface PS2 of the substrate 1. In addition, the shape of the conductor 4 in plan view may be suitably changed as long as the advantageous effects of the present invention are obtained and may be, for example, a square shape, a rectangular shape, a polygonal shape, a circular shape, an elliptical shape, an L-shape, a T-shape, or the like. Furthermore, the conductor 4 is not limited to a single conductor 4, and a plurality of conductors 4 may be formed in or. on the substrate 1.

Note that, as described in the present embodiment, some of the plurality of electronic components (the switching elements 31 and 32 and the like) are disposed at the positions where they overlap with the inductor 2 when viewed in the Y-axis direction, so that the power supply module can be easily reduced in size.

In the present embodiment, although the case has been described in which the switching elements 31 and 32 are mounted on the first surface PS1 of the substrate 1, the switching elements may be incorporated in a different electronic component such as the control IC 3. In this case, it is preferable that the above-mentioned electronic component in which the switching elements are incorporated be disposed at a position where the electronic component overlaps the capacitors 21 (at least one of the input capacitor and the output capacitor) when viewed in the Y-axis direction. In addition, in this case, it is preferable that the above-mentioned electronic component in which the switching elements are incorporated be disposed at a position where the electronic component overlaps the conductor 4, which is formed in or on the substrate 1, when viewed in the Y-axis direction.

### «Third Embodiment»

In the third embodiment, a case of a power supply module in which a plurality of electronic components are mounted only on the first surface of the substrate will be described.

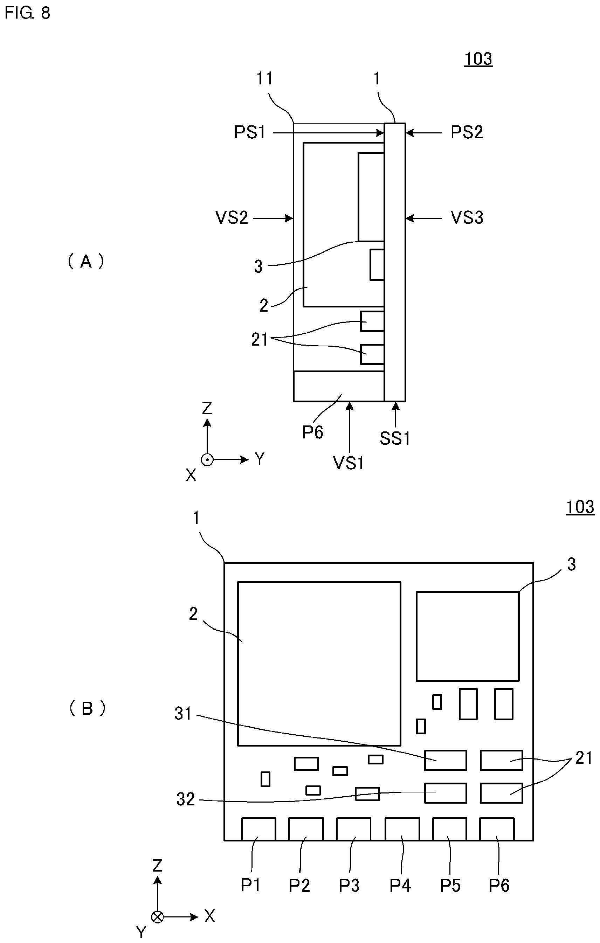

Fig. 8(A) is a front view of a power supply module 103 according to the third embodiment, and Fig. 8(B) is a left-hand side view of the power supply module 103. In Fig. 8(A) and Fig. 8(B), for ease of understanding of the structure of the power supply module 103, the first resin member 11 is illustrated as being transparent.

A difference between the power supply module 103 according to the present embodiment and the power supply module 101 according to the first embodiment is that all the plurality of electronic components (the control IC 3, the capacitors 21, the switching elements 31 and 32, and the like) are mounted only on the first surface PS1 of the substrate 1. Another difference between the power supply module 103 and the power supply module 101 is that the second resin member is not formed on the second surface PS of the substrate 1. The rest of the configuration of the power supply module 103 is substantially the same as that of the power supply module 101.

The inductor 2, the control IC 3, the capacitors 21 (the input capacitor and the output capacitor), and the switching elements 31 and 32 are mounted on the first surface PS1 of the substrate 1.

The inductor 2, the control IC 3, the capacitors 21 (the input capacitor and the output capacitor), and the switching elements 31 and 32 are buried in the first resin member 11, which is formed on the first surface PS1 of the substrate 1.

As illustrated in Fig. 8(A) and Fig. 8(B), the first outer surface VS1 of the power supply module 103 is formed so as to extend across the side surface SS1 of the substrate 1 and the first resin member 11. The second outer surface VS2 of the power supply module 103 is formed at the first resin member 11.

As described above, the configuration in which the inductor 2 and the plurality of electronic components (the control IC 3, the capacitors 21, the switching elements 31 and 32, and the like) are all mounted on the first surface PS1 of the substrate 1 and are sealed by the first resin member 11 may be employed.

In each of the first and second embodiments, although the case has been described in which the power supply module has the configuration in which the inductor 2 is mounted on the second surface PS2 of the substrate 1 and is sealed by the second resin member, the present invention is not limited to this configuration. As described in the present embodiment, the inductor 2 may be mounted on the first surface PS1 of the substrate 1 and may be sealed by the first resin member 11.

### «Fourth Embodiment»

In the fourth embodiment, a case of the power supply module that is not a step-down DC-DC converter module will be described.

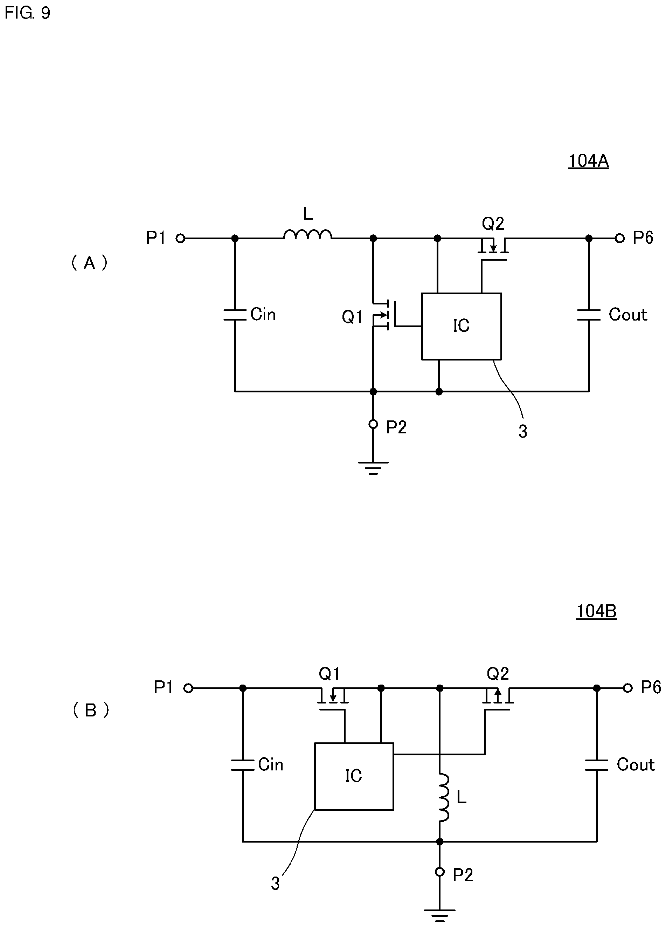

Fig. 9(A) is a circuit diagram of a power supply module 104A according to the fourth embodiment, and Fig. 9(B) is a circuit diagram of another power supply module 104B according to the fourth embodiment.

In the power supply module 104A, as illustrated in Fig. 9(A), the inductor L and the switching element Q2 are connected between the terminal electrode P1 and the terminal electrode P6. The switching element Q2 is connected between the terminal electrode P6 and the inductor L, and the switching element Q1 is connected between the terminal electrode P2 (the ground) and the inductor L. The input capacitor Cin is connected between the terminal electrode P1 and the terminal electrode P2 (the ground), and the output capacitor Cout is connected between the terminal electrode P2 and the terminal electrode P2 (the ground). The control IC 3 is connected to the switching elements Q1 and Q2.

More specifically, the first end of the inductor L is connected to the terminal electrode P1, and the source of the switching element Q2 is connected to the second end of the inductor L. The drain of the switching element Q2 is connected to the terminal electrode P6. The drain of the switching element Q1 is connected to the second end of the inductor L, and the source of the switching element Q1 is connected to the terminal electrode P2 (the ground). The first end of the input capacitor Cin is connected to the terminal electrode P1, and the second end of the input capacitor Cin is connected to the terminal electrode P2 (the ground). The first end of the output capacitor Cout is connected to the terminal electrode P6, and the second end of the output capacitor Cout is connected to the terminal electrode P2 (the ground). The control IC 3 is connected to the gate and the source of each of the switching elements Q1 and Q2.

As described above, the power supply module 104A forms a step-up DC-DC converter module.

Next, in the power supply module 104B, as illustrated in Fig. 9(B), the switching element Q1 and the switching element Q2 are connected between the terminal electrode P1 and the terminal electrode P6. The inductor L is connected between the switching elements Q1 and Q2 and the terminal electrode P2 (the ground).

More specifically, the drain of the switching element Q1 is connected to the terminal electrode P1, and the source of the switching element Q1 is connected to the first end of the inductor L. The drain of the switching element Q2 is connected to the first end of the inductor L. The second end of the inductor L is connected to the terminal electrode P2 (the ground), and the source of the switching element Q2 is connected to the terminal electrode P6. The control IC 3 is connected to the gate and the source of each of the switching elements Q1 and Q2.

As described above, the power supply module 104B forms a step-up and step-down DC-DC converter module.

As described in the present embodiment, the power supply module according to the present invention may form not only a step-down DC-DC converter but also a step-up DC-DC converter and a step-up and step-down DC-DC converter module. In addition, the power supply module according to the present invention is not limited to a DC-DC converter and may form an AC-DC converter module or a DC-AC converter module.

### «Fifth Embodiment»

In the fifth embodiment, a power supply device that includes three power supply modules 101 will be described.

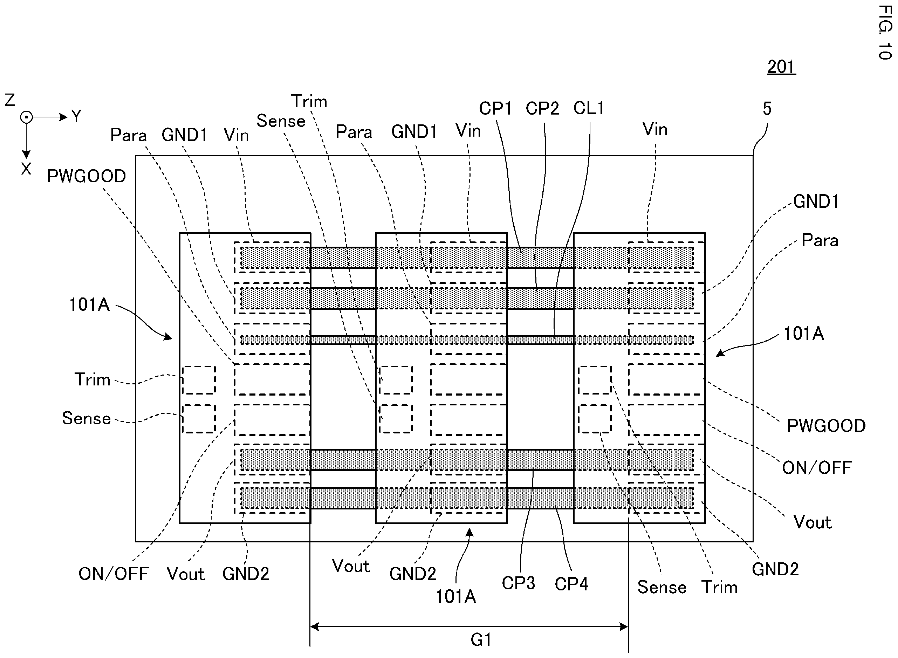

Fig. 10 is a plan view illustrating a principal portion of a power supply device 201 according to the fifth embodiment that includes power supply modules according to the present invention. In Fig. 10, for ease of understanding of the structure, terminal electrodes Vin, Vout, GND1, GND2, Para, ON/OFF, PWGOOD, Trim, and Sense are each indicated by a dashed line. In addition, in Fig. 10, for ease of understanding of the structure, conductor patterns CP1, CP2, CP3, CP4, and CL1 are each indicated by a dot pattern.

The power supply device 201 according to the present embodiment includes a mounting substrate 5 and three power supply modules 101A. Each of the power supply modules 101A is substantially the same as the power supply module 101 described in the first embodiment. The difference between each of the power supply modules 101 A and the power supply module 101 according to the first embodiment is that the power supply module 101A includes the nine terminal electrodes Vin, Vout, GND1, GND2, Para, ON/OFF, PWGOOD, Trim, and Sense. The terminal electrodes Vin, GND1, Para, PWGOOD, ON/OFF, Vout, and GND2 are each formed in or on a portion of a first outer surface (a mounting surface) and are successively arranged in the first direction (the X-axis direction) along the ridge of the first outer surface and a second outer surface. The terminal electrodes Trim and Sense are formed in or on a portion of the first outer surface (the mounting surface) and are successively arranged in the first direction (the X-axis direction) along the ridge of the first outer surface and the second outer surface.

The five conductor patterns CP1, CP2, CP3, CP4, and CL1 are formed on the mounting substrate 5. The five conductor patterns CP1, CP2, CP3, CP4, and CL1 are formed on a surface of the mounting substrate 5. The five conductor patterns CP1, CP2, CP3, CP4, and CL1 are linear conductor patterns extending in the Y-axis direction and are arranged in the X-axis direction. The conductor patterns CP1, CP2, CP3, and CP4 are conductor patterns for power supply wiring, and a large current flows therethrough. Consequently, the conductor patterns CP1, CP2, CP3, and CP4 each have a line width larger than that of the conductor pattern CL1. The conductor pattern CL1 is a conductor pattern for signal wiring.

The three power supply modules 101 are mounted on the mounting substrate 5. Each of the power supply modules 101 is mounted on the mounting substrate 5 by using, for example, an electrically conductive bonding material such as solder.

As illustrated in Fig. 10, the three power supply modules 101 are arranged in a second direction (the Y-axis direction) that is perpendicular to the first direction (the X-axis direction) along the ridge of the first outer surface and the second outer surface and are electrically connected in parallel to one another.

More specifically, the terminal electrodes Vin of the three power supply modules 101 are connected in parallel to one another by the conductor pattern CP1, and the terminal electrodes GND1 of the three power supply modules 101 are connected in parallel to one another by the conductor pattern CP2. The terminal electrodes Vout of the three power supply modules 101 are connected in parallel to one another by the conductor pattern CP3, and the terminal electrodes GND2 of the three power supply modules 101 are connected in parallel to one another by the conductor pattern CP4. The terminal electrodes Para of the three power supply modules 101 are connected in parallel to one another by the conductor pattern CL1.

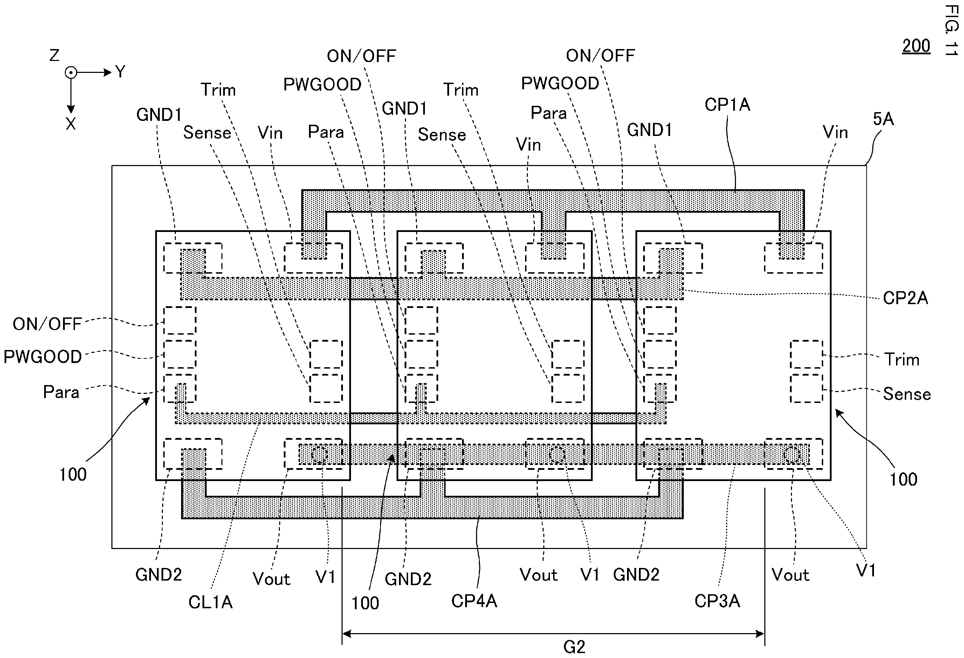

Fig. 11 is a plan view illustrating a principal portion of a power supply device 200 of a comparative example that includes power supply modules 100. In Fig. 11, for ease of understanding of the structure, the terminal electrodes Vin, Vout, GND1, GND2, Para, ON/OFF, PWGOOD, Trim, and Sense are each indicated by a dashed line. In addition, in Fig. 11, for ease of understanding of the structure, the conductor patterns CP1, CP2, CP3, CP4, and CL1 are each indicated by a dot pattern.

The power supply device 200 of the comparative example includes a mounting substrate 5A and the three power supply modules 100. Each of the power supply modules 100 is a power supply module that includes a substrate having first and second surfaces on which a plurality of electronic components and an inductor are mounted, the first surface and the second surface being parallel to a mounting surface. The nine terminal electrodes Vin, Vout, GND1, GND2, Para, ON/OFF, PWGOOD, Trim, and Sense of each of the power supply modules 100 are terminal electrodes that correspond to the nine terminal electrodes Vin, Vout, GND1, GND2, Para, ON/OFF, PWGOOD, Trim, and Sense of each of the power supply modules 101A.

The five conductor patterns CP1A, CP2A, CP3A, CP4A, and CL1A and three interlayer connection conductors V1 are formed in or on the mounting substrate 5A. The conductor patterns CP1A, CP2A, CP4A, and CL1A are formed on a surface of the mounting substrate 5A. The conductor patterns CP3A and the three interlayer connection conductors V1 are formed in the mounting substrate 5A. The conductor pattern CP3A is a conductor pattern that is formed in the mounting substrate 3A due to the relationship with the other wiring lines and is routed to the surface of the mounting substrate 5A via the interlayer connection conductors V1.

The conductor patterns CP1A, CP2A, CP3A, CP4A, and CL1A are linear conductor pattern extending in the Y-axis direction and are arranged in the X-axis direction. As illustrated in Fig. 11, the three power supply modules 100 are mounted on the mounting substrate 5A so as to be arranged in the second direction (the Y-axis direction) and are electrically connected in parallel to one another.

More specifically, the terminal electrodes Vin of the three power supply modules 100 are connected in parallel to one another by the conductor pattern CP1A, and the terminal electrodes GND1 of the three power supply modules 100 are connected in parallel to one another by the conductor pattern CP2A. The terminal electrodes Vout of the three power supply modules 100 are connected in parallel to one another by the conductor pattern CP3A and the three interlayer connection conductors V1, and the terminal electrodes GND2 of the three power supply modules 100 are connected in parallel to one another by the conductor pattern CP4A. The terminal electrodes Para of the three power supply modules 100 are connected in parallel to one another by the conductor pattern CL1A.

The power supply device 201 according to the present embodiment exhibits the following advantageous effects.

The power supply device 201 according to the present embodiment has a structure in which the three power supply modules 101 are arranged in the second direction (the Y-axis direction). Thus, the length of a wiring line (a conductor pattern having high conductor resistance) for connecting a plurality of power supply modules to one another can be shorter than that in the case where a power supply module having a structure in which a substrate thereof has a first surface and a second surface that are parallel to a mounting surface is mounted onto the mounting substrate (see a wiring distance G1 in Fig. 10 and a wiring distance G2 in Fig. 11). Therefore, compared with the case where a power supply module having a structure in which a substrate thereof has a first surface and a second surface that are parallel to a mounting surface is mounted onto the mounting substrate, the lower-loss power supply device 201 can be realized.

In addition, in the power supply device 201 according to the present embodiment, the plurality of power supply modules 101A can be connected in parallel to one another by the linear conductor patterns CP1, CP2, CP3, CP4, and CL1. In other words, in the present embodiment, the plurality of power supply modules 101A can be connected in parallel to one another by simple wiring. Therefore, according to the present embodiment, it is not necessary to route a complex wiring line (e.g., the conductor pattern CP3A illustrated in Fig. 11) for connecting a plurality of power supply modules in parallel to one another, and the plurality of power supply modules may easily be connected to one another.

According to the present embodiment, the plurality of power supply modules 101A are connected to one another by the conductor patterns CP1, CP2, CP3, CP4, and CL1, which linearly extend. In other words, the plurality of power supply modules 101A can be connected in parallel to one another at the shortest distance, and thus, the low-loss power supply device 201 can be realized. In addition, since the plurality of power supply modules are connected in parallel to one another at the shortest distance, unstable operation of the power supply device due to exogenous noise is suppressed. Furthermore, by connecting the plurality of power supply modules in parallel to one another at the shortest distance, variations in load current between the power supply modules 101A due to a difference in the wiring length can be reduced, and the operational stability of the power supply device is improved.

In the power supply device 201 according to the present embodiment, since the power supply modules 101A that are stably mountable are used, the power supply modules 101A can be mounted onto the mounting substrate 5 in a reflow process. Thus, the number of steps is smaller than that in a flow process, and the power supply modules 101A can be easily mounted onto the mounting substrate 5. In addition, in each of the power supply modules 101A, the plurality of electronic components and the inductor are each sealed by the resin member (the first resin member or the second resin member), and thus, connecting portions, such as solder portions, each of which connects one of the plurality of electronic components (or the inductor) to the substrate 1 are protected even at high temperature during the reflow process. Furthermore, even in the case where the connecting portions, such as solder portions, melt once at high temperature during the reflow process, the resin member (the first resin member or the second resin member) and the substrate 1 are joined to each other as a result of resins being bonded together, and the plurality of electronic components and the inductor do not fall off. After cooling, the joining state of each of the connecting portions, such as solder portions, returns to normal.

Note that, in the present embodiment, although the case has been described in which the power supply device 201 includes the three power supply modules 101A, the present invention is not limited to this configuration. The number of power supply modules may be suitably changed.

### «Other Embodiments»

In each of the above embodiments, although the case has been described in which the shape of the substrate 1 in plan view is a rectangular shape, the present invention is not limited to this configuration. The shape of the substrate 1 in plan view may be suitably changed as long as the advantageous effects of the present invention are obtained and may be, for example, a circular shape, an elliptical shape, a polygonal shape, an L-shape, a T-shape, a Y-shape, or the like. In addition, although the power supply modules each having a rectangular parallelepiped shape have been described in the first, second, and third embodiments, the present invention is not limited to this configuration. The shape of each of the power supply modules may be suitably changed as long as the advantageous effects of the present invention are obtained. The surfaces of the power supply module excluding the mounting surface (the first outer surface VS1) are not limited to flat surfaces and may be curved surfaces and the like.

In the above embodiments, although the power supply modules each of which includes the control IC 3, the capacitors 21 (the input capacitor and the output capacitor), the switching elements 31 and 32, and the inductor 2 have been described, each of the power supply modules may include or does not need to include an electronic component other than these components. The plurality of electronic components may include, for example, a power inductor, a choke coil, a transformer.

In addition, the number, the type, the arrangement, and the like of the plurality of electronic components included in the power supply module may be suitably changed as long as the advantageous effects of the present invention are obtained. Furthermore, each of the plurality of electronic components may be mounted either on the first surface PS1 of the substrate 1 or on the second surface PS2 of the substrate 1. However, as described in the second embodiment, it is preferable that the switching elements 31 and 32 be mounted on one of the first surface PS1 and the second surface PS2, the one surface being different from the other surface on which the capacitors 21 (the input capacitor and the output capacitor) are mounted.

In each of the above embodiments, although a configuration example has been described in which the six terminal electrodes P1, P2, P3, P4, P5, and P6 are formed so as to extend from a portion of the first outer surface VS1 to a portion of the second outer surface VS2 and are exposed at the first outer surface VS1 and the second outer surface VS2, the present invention is not limited to this configuration. The terminal electrodes may at least be exposed at the first outer surface VS1.

In each of the above embodiments, although the case has been described in which the six terminal electrodes P1, P2, P3, P4, P5, and P6 are arranged in the first direction (the X-axis direction) along the ridge of the first outer surface VS1 and the second outer surface VS2, the present invention is not limited to this configuration. The number, the arrangement, and the like of the terminal electrodes may be suitably changed as long as the advantageous effects of the present invention are obtained. In addition, each of the terminal electrodes is not limited to a metal block having a rectangular parallelepiped shape and may have an elliptical columnar shape, a polygonal columnar shape, or the like.

Lastly, the descriptions of the above embodiments are examples in all respects, and the present invention is not to be considered limited to the embodiments. Modifications and changes may be suitably made by those skilled in the art. The scope of the present invention is to be determined not by the above-described embodiments, but by the claims. In addition, changes within the scope of the claims made to the embodiments are included in the scope of the present invention.

### Reference Signs List

Cin input capacitor
Cout output capacitor
L inductor
Q1, Q2 switching element
D1, D2 section
LIp loop
P1, P2, P3, P4, P5, P6, Vin, Vout, GND1, GND2, ON/OFF, Trim, Sense, PWGOOD, Para terminal electrode
PS1 first surface of substrate
PS2 second surface of substrate
VS1 first outer surface
VS2 second outer surface
VS3 third outer surface
CP1, CP1A, CP2, CP2A, CP3, CP3A, CP4, CP4A, CL1, CL1A conductor pattern
G1, G2 wiring distance
1 substrate
2 inductor
3 control IC
4 conductor
5, 5A mounting substrate
11 first resin member
12 second resin member
21 capacitor (input capacitor and output capacitor)
31, 32 switching element
100, 101, 102, 103 power supply module
200, 201 power supply device

## Claims

1. A power supply module having a first outer surface (VS1) and a second outer surface (VS2) that is adjacent to the first outer surface (VS1) and perpendicular to the first outer surface (VS1), the power supply module comprising:
a substrate (1) that has a first surface (PS1), a second surface (PS2) that is opposite to the first surface (PS1), and a side surface;
a plurality of electronic components that are mounted at least on the first surface (PS1) and the second surface (PS2);
a first resin member (11) and a second resin member (12) that are respectively formed on the first surface (PS1) and the second surface (PS2) and that seal the electronic components mounted on the first surface (PS1) and the second surface (PS2); and
a terminal electrode (P1, P2, P3, P4, P5, P6) that is exposed at least at the first outer surface (VS1),
wherein, in the substrate (1), the first surface (PS1) and the second surface (PS2) are perpendicular to the first outer surface (VS1),
wherein the first outer surface (VS1) is formed so as to extend at least across the side surface of the substrate (SS1), the first resin member (11) and the second resin member (12), and
wherein an area of the first outer surface (VS1) is smaller than an area of the second outer surface (VS2), **characterized in that** the first outer surface (VS1) is configured as a mounting surface and the thicknesses of the resin members (11, 12) are chosen such that the first outer surface (VS1) has a surface area that ensures stable surface-to-surface mounting on a motherboard.

2. The power supply module according to Claim 1, further comprising:
an inductor (2) that is mounted on the first surface (PS1) or the second surface (PS2) and sealed by the first resin member (11) or the second resin member (12),
wherein some of the plurality of electronic components are disposed at positions at which the some of the plurality of electronic components overlap the inductor (2) when the first surface (PS1) or the second surface (PS2) is viewed in plan view,
wherein the plurality of electronic components include an input capacitor (Cin) that is connected to an input portion, an output capacitor (Cout) that is connected to an output portion, and a switching element (Q1, Q2) that is connected between the inductor (2) and the input capacitor (Cin) or between the inductor (2) and the output capacitor (Cout) and that switches on and off a current that flows through the inductor (2),
wherein the input capacitor (Cin) and the output capacitor (Cout) are mounted on one of the first surface (PS1) and the second surface (PS2), and
wherein the switching element (Q1, Q2) is mounted on one of the first surface (PS1) and the second surface (PS2), the one surface being different from the other surface on which the input capacitor (Cin) and the output capacitor (Cout) are mounted.

3. The power supply module according to Claim 2,
wherein the plurality of electronic components includes an input capacitor (Cin) that is connected to an input portion, an output capacitor (Cout) that is connected to an output portion, and at least one switching element (Q1, Q2) that is connected between the inductor (2) and the input capacitor (Cin) and between the inductor (2) and the output capacitor (Cout) and that switches on and off a current that flows through the inductor (2),
wherein the input capacitor (Cin) and the output capacitor (Cout) are mounted on one of the first surface (PS1) and the second surface (PS2), and
wherein the switching element (Q1, Q2) is mounted on one of the first surface (PS1) and the second surface (PS2), the one surface being different from the other surface on which the input capacitor (Cin) and the output capacitor (Cout) are mounted.

4. The power supply module according to any one of Claims 2 to 3, wherein the switching element (Q1, Q2) is disposed at a position where at least a portion of the switching element (Q1, Q2) overlaps at least one of the input capacitor (Cin) and the output capacitor (Cout) when the first surface (PS1) or the second surface (PS2) is viewed in plan view.

5. The power supply module according to any one of Claims 2 to 4, further comprising:
a conductor that is formed in or on the substrate (1), wherein the switching element (Q1, Q2) is disposed at a position where at least a portion of the switching element (Q1, Q2) overlaps the conductor when the first surface (PS1) or the second surface (PS2) is viewed in plan view.

6. The power supply module according to any one of Claims 1 to 5,
wherein the terminal electrode (P1, P2, P3, P4, P5, P6) is a columnar electrode mounted on the first surface (PS1) and is formed so as to extend from a portion of the first outer surface (VS1) to a portion of the second outer surface (VS2).

7. The power supply module according to any one of Claims 1 to 6,
wherein a plurality of the terminal electrodes (P1, P2, P3, P4, P5, P6) are provided, and
wherein the plurality of terminal electrodes (P1, P2, P3, P4, P5, P6) are arranged in a first direction along a ridge of the first outer surface (VS1) and the second outer surface (VS2).

8. A power supply device comprising: a mounting substrate (5, 5A); and
a plurality of power supply modules (100, 101, 102, 103) according to any of the claims 1 to 7,
wherein the plurality of power supply modules (100, 101, 102, 103) are arranged in a second direction that is perpendicular to a first direction along a ridge of the first outer surface (VS1) and the second outer surface (VS2) and are electrically connected in parallel to each other.

9. The power supply device according to Claim 8, wherein the plurality of power supply modules (100, 101, 102, 103) are mounted on the mounting substrate (5, 5A) by using solder.

10. The power supply module according to Claim 1, further comprising:
a plurality of further outer surfaces that are adjacent to the first outer surface (VS1) and perpendicular to the first outer surface (VS1),
wherein an area of the first outer surface (VS1) is smaller than an area of any of the second (VS2) and the further outer surfaces.

11. The power supply module according to Claim 10, further comprising:
an inductor (2) that is mounted on the second surface (PS2), wherein the terminal electrode (P1, P2, P3, P4, P5, P6) is provided on the first surface (PS1).

## Patentansprüche

1. Stromversorgungsmodul, das eine erste Außenfläche (VS1) und eine zweite Außenfläche (VS2) aufweist, die benachbart zu der ersten Außenfläche (VS1) und senkrecht zu der ersten Außenfläche (VS1) ist, wobei das Stromversorgungsmodul aufweist:
ein Substrat (1), das eine erste Oberfläche (PS1), eine zweite Oberfläche (PS2), die der ersten Oberfläche (PS1) gegenüberliegt, und eine Seitenfläche aufweist;
eine Vielzahl von elektronischen Komponenten, die mindestens an der ersten Oberfläche (PS1) und der zweiten Oberfläche (PS2) montiert sind;
ein erstes Harzelement (11) und ein zweites Harzelement (12), die jeweils an der ersten Oberfläche (PS1) und der zweiten Oberfläche (PS2) gebildet sind und die die elektronischen Komponenten abdichten, die an der ersten Oberfläche (PS1) und der zweiten Oberfläche (PS2) montiert sind; und
eine Anschlusselektrode (P1, P2, P3, P4, P5, P6), die mindestens an der ersten Außenfläche (VS1) freiliegt,
wobei in dem Substrat (1) die erste Oberfläche (PS1) und die zweite Oberfläche (PS2) senkrecht zu der ersten Außenfläche (VS1) sind,
wobei die erste Außenfläche (VS1) derart gebildet ist, dass sie sich mindestens über die Seitenfläche des Substrats (SS1), das erste Harzelement (11) und das zweite Harzelement (12) erstreckt, und
wobei eine Fläche der ersten Außenfläche (VS1) kleiner ist als eine Fläche der zweiten Außenfläche (VS2), **dadurch gekennzeichnet, dass** die erste Außenfläche (VS1) als eine Montagefläche ausgestaltet ist und die Dicken der Harzelemente (11, 12) derart gewählt sind, dass die erste Außenfläche (VS1) einen Flächeninhalt aufweist, der eine stabile Montage von Oberfläche zu Oberfläche an einer Hauptplatine sicherstellt.

2. Stromversorgungsmodul nach Anspruch 1, ferner aufweisend:
einen Induktor (2), der an der ersten Oberfläche (PS1) oder der zweiten Oberfläche (PS2) montiert ist und von dem ersten Harzelement (11) oder dem zweiten Harzelement (12) abgedichtet wird,
wobei einige der Vielzahl von elektronischen Komponenten an Positionen angeordnet sind, an denen die einigen der Vielzahl von elektronischen Komponenten den Induktor (2) überlappen, wenn die erste Oberfläche (PS1) oder die zweite Oberfläche (PS2) in Draufsicht betrachtet wird,
wobei die Vielzahl von elektronischen Komponenten einen Eingangskondensator (Cin), der mit einem Eingangsabschnitt verbunden ist,
einen Ausgangskondensator (Cout), der mit einem Ausgangsabschnitt verbunden ist, und ein Schaltelement (Q1, Q2) aufweisen, das zwischen dem Induktor (2) und dem Eingangskondensator (Cin) oder zwischen dem Induktor (2) und dem Ausgangskondensator (Cout) verbunden ist und das einen Strom, der durch den Induktor (2) fließt, ein- und ausschaltet,
wobei der Eingangskondensator (Cin) und der Ausgangskondensator (Cout) an der ersten Oberfläche (PS1) oder der zweiten Oberfläche (PS2) montiert sind, und
wobei das Schaltelement (Q1, Q2) an der ersten Oberfläche (PS1) oder der zweiten Oberfläche (PS2) montiert ist, wobei die eine Oberfläche sich von der anderen Oberfläche unterscheidet, an der der Eingangskondensator (Cin) und der Ausgangskondensator (Cout) montiert sind.

3. Stromversorgungsmodul nach Anspruch 2,
wobei die Vielzahl von elektronischen Komponenten einen Eingangskondensator (Cin), der mit einem Eingangsabschnitt verbunden ist,
einen Ausgangskondensator (Cout), der mit einem Ausgangsabschnitt verbunden ist, und mindestens ein Schaltelement (Q1, Q2) aufweisen, das zwischen dem Induktor (2) und dem Eingangskondensator (Cin) und zwischen dem Induktor (2) und dem Ausgangskondensator (Cout) verbunden ist und das einen Strom, der durch den Induktor (2) fließt, ein- und ausschaltet,
wobei der Eingangskondensator (Cin) und der Ausgangskondensator (Cout) an der ersten Oberfläche (PS1) oder der zweiten Oberfläche (PS2) montiert sind, und
wobei das Schaltelement (Q1, Q2) an der ersten Oberfläche (PS1) oder der zweiten Oberfläche (PS2) montiert ist, wobei die eine Oberfläche sich von der anderen Oberfläche unterscheidet, an der der Eingangskondensator (Cin) und der Ausgangskondensator (Cout) montiert sind.

4. Stromversorgungsmodul nach einem der Ansprüche 2 bis 3, wobei
das Schaltelement (Q1, Q2) an einer Position angeordnet ist, an der mindestens ein Abschnitt des Schaltelements (Q1, Q2) den Eingangskondensator (Cin) und/oder den Ausgangskondensator (Cout) überlappt, wenn die erste Oberfläche (PS1) oder die zweite Oberfläche (PS2) in Draufsicht betrachtet wird.

5. Stromversorgungsmodul nach einem der Ansprüche 2 bis 4, ferner aufweisend:
einen Leiter, der in oder an dem Substrat (1) gebildet ist, wobei das Schaltelement (Q1, Q2) an einer Position angeordnet ist, an der mindestens ein Abschnitt des Schaltelements (Q1, Q2) den Leiter überlappt, wenn die erste Oberfläche (PS1) oder die zweite Oberfläche (PS2) in Draufsicht betrachtet wird.

6. Stromversorgungsmodul nach einem der Ansprüche 1 bis 5,
wobei die Anschlusselektrode (P1, P2, P3, P4, P5, P6) eine säulenförmige Elektrode ist, die an der ersten Oberfläche (PS1) montiert ist und derart gebildet ist, dass sie sich von einem Abschnitt der ersten Außenfläche (VS1) zu einem Abschnitt der zweiten Außenfläche (VS2) erstreckt.

7. Stromversorgungsmodul nach einem der Ansprüche 1 bis 6,
wobei eine Vielzahl der Anschlusselektroden (P1, P2, P3, P4, P5, P6) vorgesehen sind, und
wobei die Vielzahl von Anschlusselektroden (P1, P2, P3, P4, P5, P6) in einer ersten Richtung entlang einer Kante der ersten Außenfläche (VS1) und der zweiten Außenfläche (VS2) angeordnet sind.

8. Stromversorgungsvorrichtung, aufweisend:
ein Montagesubstrat (5, 5A); und
eine Vielzahl von Stromversorgungsmodulen (100, 101, 102, 103) nach einem der Ansprüche 1 bis 7,
wobei die Vielzahl von Stromversorgungsmodulen (100, 101, 102, 103) in einer zweiten Richtung, die senkrecht zu einer ersten Richtung ist, entlang einer Kante der ersten Außenfläche (VS1) und der zweiten Außenfläche (VS2) angeordnet sind und elektrisch zueinander parallelgeschaltet sind.

9. Stromversorgungsvorrichtung nach Anspruch 8, wobei die Vielzahl von Stromversorgungsmodulen (100, 101, 102, 103) unter Verwendung von Lot an dem Montagesubstrat (5, 5A) montiert sind.

10. Stromversorgungsmodul nach Anspruch 1, ferner aufweisend:
eine Vielzahl von weiteren Außenflächen, die benachbart zu der ersten Außenfläche (VS1) und senkrecht zu der ersten Außenfläche (VS1) sind,
wobei eine Fläche der ersten Außenfläche (VS1) kleiner ist als eine Fläche von jeder der zweiten (VS2) und der weiteren Außenflächen.

11. Stromversorgungsmodul nach Anspruch 10, ferner aufweisend:
einen Induktor (2), der an der zweiten Oberfläche (PS2) montiert ist, wobei die Anschlusselektrode (P1, P2, P3, P4, P5, P6) an der ersten Oberfläche (PS1) vorgesehen ist.

## Revendications

1. Module d'alimentation électrique comportant une première surface externe (VS1) et une seconde surface externe (VS2) adjacente à la première surface externe (VS1) et perpendiculaire à la première surface externe (VS1), le module d'alimentation électrique comprenant :
un substrat (1) comportant une première surface (PS1), une seconde surface (PS2) opposée à la première surface (PS1), et une surface latérale ;
une pluralité de composants électroniques montés au moins sur la première surface (PS1) et sur la seconde surface (PS2) ;
un premier élément en résine (11) et un second élément en résine (12), formés respectivement sur la première surface (PS1) et sur la seconde surface (PS2) et destinés à isoler les composants électroniques montés sur la première surface (PS1) et sur la seconde surface (PS2) ; et
une électrode de borne (P1, P2, P3, P4, P5, P6) exposée au moins au niveau de la première surface externe (VS1),
dans le premier substrat (1), la première surface (PS1) et la seconde surface (PS2) étant perpendiculaires à la première surface externe (VS1),
la première surface externe (VS1) étant formée de façon à s'étendre au moins en travers de la surface latérale du substrat (SS1), du premier élément en résine (11) et du second élément en résine (12), et
une superficie de la première surface externe (VS1) étant plus petite qu'une superficie de la seconde surface externe (VS2), **caractérisé en ce que** la première surface externe (VS1) est conçue sous forme de surface de montage, et les épaisseurs des éléments en résine (11, 12) sont choisies de sorte que la première surface externe (VS1) présente une surface active permettant d'assurer un montage surface-à-surface stable sur une carte mère.

2. Le module d'alimentation électrique selon la Revendication 1, comprenant en outre :
une bobine d'induction (2) montée sur la première surface (PS1) ou sur la seconde surface (PS2) et isolée par le premier élément en résine (11) ou par le second élément en résine (12), et
dans lequel certains composants, parmi la pluralité de composants électroniques, sont disposés à des positions au niveau desquelles lesdits composants, parmi la pluralité de composants électroniques, chevauchent la bobine d'induction (2) lorsque la première surface (PS1) ou la seconde surface (PS2) est visualisée en vue en plan,
dans lequel la pluralité de composants électroniques comprend un condensateur d'entrée (Cin) connecté à une partie d'entrée, un condensateur de sortie (Cout) connecté à une partie de sortie, et un élément de commutation (Q1, Q2) connecté entre la bobine d'induction (2) et le condensateur d'entrée (Cin), ou entre la bobine d'induction (2) et le condensateur de sortie (Cout), et destiné à mettre en circuit et hors circuit un courant circulant à travers la bobine d'induction (2),
dans lequel le condensateur d'entrée (Cin) et le condensateur de sortie (Cout) sont montés sur la première surface (PS1) ou sur la seconde surface (PS2), et
dans lequel l'élément de commutation (Q1, Q2) est monté sur la première surface (PS1) ou sur la seconde surface (PS2), ladite surface étant différente de l'autre surface sur laquelle le condensateur d'entrée (Cin) et le condensateur de sortie (Cout) sont montés.

3. Le module d'alimentation électrique selon la Revendication 2,
dans lequel la pluralité de composants électroniques comprend un condensateur d'entrée (Cin) connecté à une partie d'entrée, un condensateur de sortie (Cout) connecté à une partie de sortie, et au moins un élément de commutation (Q1, Q2) connecté entre la bobine d'induction (2) et le condensateur d'entrée (Cin) et entre la bobine d'induction (2) et le condensateur de sortie (Cout), et destiné à mettre en circuit et hors circuit un courant circulant à travers la bobine d'induction (2),
dans lequel le condensateur d'entrée (Cin) et le condensateur de sortie (Cout) sont montés sur la première surface (PS1) ou sur la seconde surface (PS2), et
dans lequel l'élément de commutation (Q1, Q2) est monté sur la première surface (PS1) ou sur la seconde surface (PS2), ladite surface étant différente de l'autre surface sur laquelle le condensateur d'entrée (Cin) et le condensateur de sortie (Cout) sont montés.

4. Le module d'alimentation électrique selon l'une quelconque des Revendications 2 à 3, dans lequel
l'élément de commutation (Q1, Q2) est disposé au niveau d'une position où au moins une partie de l'élément de commutation (Q1, Q2) chevauche le condensateur d'entrée (Cin) et/ou le condensateur de sortie (Cout) lorsque la première surface (PS1) ou la seconde surface (PS2) est visualisée en vue en plan.

5. Le module d'alimentation électrique selon l'une quelconque des Revendications 2 à 4, comprenant en outre :
un conducteur formé dans ou sur le substrat (1), l'élément de commutation (Q1, Q2) étant disposé au niveau d'une position où au moins une partie de l'élément de commutation (Q1, Q2) chevauche le conducteur lorsque la première surface (PS1) ou la seconde surface (PS2) est visualisée en vue en plan.

6. Le module d'alimentation électrique selon l'une quelconque des Revendications 1 à 5,
dans lequel l'électrode de borne (P1, P2, P3, P4, P5, P6) est une électrode colonnaire montée sur la première surface (PS1), et elle est formée de façon à s'étendre d'une partie de la première surface externe (VS1) à une partie de la seconde surface externe (VS2).

7. Le module d'alimentation électrique selon l'une quelconque des Revendications 1 à 6,
dans lequel une pluralité des électrodes de borne (P1, P2, P3, P4, P5, P6) est utilisée, et
dans lequel la pluralité d'électrodes de borne (P1, P2, P3, P4, P5, P6) est agencée dans une première direction le long d'une arête de la première surface externe (VS1) et de la seconde surface externe (VS2).

8. Dispositif d'alimentation électrique comprenant : un substrat de montage (5, 5A) ; et
une pluralité de modules d'alimentation électrique (100, 101, 102, 103) selon l'une quelconque des Revendications 1 à 7,
dans lequel la pluralité de modules d'alimentation électrique (100, 101, 102, 103) est agencée dans une seconde direction perpendiculaire à une première direction le long d'une arête de la première surface externe (VS1) et de la seconde surface externe (VS2), les modules étant connectés les uns aux autres en parallèle.

9. Le dispositif d'alimentation électrique selon la Revendication 8, dans lequel la pluralité de modules d'alimentation électrique (100, 101, 102, 103) est montée sur le substrat de montage (5, 5A) à l'aide d'une soudure.

10. Le module d'alimentation électrique selon la Revendication 1, comprenant en outre :
une pluralité de surfaces externes supplémentaires adjacentes à la première surface externe (VS1) et perpendiculaires à la première surface externe (VS1),
dans lequel une superficie de la première surface externe (VS1) est plus petite qu'une superficie de l'une quelconque des surfaces parmi la seconde surface externe (VS2) et les surfaces externes supplémentaires.

11. Le module d'alimentation électrique selon la Revendication 10, comprenant en outre :
une bobine d'induction (2) montée sur la seconde surface (PS2), l'électrode de borne (P1, P2, P3, P4, P5, P6) étant agencée sur la première surface (PS1).
